Europäisches Patentamt

European Patent Office

Office européen des brevets

(19)

(11) Veröffentlichungsnummer : **0 121 223**
**B1**

(12) **EUROPÄISCHE PATENTSCHRIFT**

(45) Veröffentlichungstag der Patentschrift :
16.06.87

(51) Int. Cl.⁴ : **H 04 Q 1/14**

(21) Anmeldenummer : **84103392.1**

(22) Anmeldetag : **27.03.84**

(54) **Verteilerleiste mit einer Mehrzahl von den abisolierfreien Anschluss elektrischer Leiter gestattenden Doppelanschlussklemmen.**

(30) Priorität : 29.03.83 DE 3311459
30.03.83 DE 3311695

(43) Veröffentlichungstag der Anmeldung :
10.10.84 Patentblatt 84/41

(45) Bekanntmachung des Hinweises auf die Patenterteilung : 16.06.87 Patentblatt 87/25

(84) Benannte Vertragsstaaten :
AT BE CH FR GB IT LI NL SE

(56) Entgegenhaltungen :
DE-A- 2 433 314
DE-A- 2 629 397
DE-A- 2 719 269
DE-B- 2 642 779
FR-A- 2 327 653
US-A- 3 760 328

(73) Patentinhaber : **Siemens Aktiengesellschaft Berlin und München**
**Wittelsbacherplatz 2**
**D-8000 München 2 (DE)**

(72) Erfinder : **Scholtholt, Hans**
**Tannenstrasse 4**
**D-8044 Lohhof (DE)**
Erfinder : **Dolansky, Franz**
**Buschingstrasse 41**
**D-8000 München 80 (DE)**
Erfinder : **Steiner, Ewald**
**Fichtenweg 11**
**D-8137 Berg 3 (DE)**

EP 0 121 223 B1

## Beschreibung

Die Erfindung betrifft eine Verteilerleiste mit einer Mehrzahl von den abisolierfreien Anschluß elektrischer Leiter gestattenden Doppelanschlußklemmen, die an den oberen Längsseiten eines Isolierstoffkörpers in Aufnahmen gehalten sind, wobei die Verteilerleiste einen annähernd quadratischen Querschnitt aufweist.

Eine derartige Verteilerleiste, die als Anschlußleiste dient, ist z. B. aus der DE-OS-2 719 269 und aus dem Aufsatz « Lötfreie Anschlußtechnik für Fernmeldeverteilereinrichtungen » in « telcom report », 1981, Heft 5, Seiten 409 ff, bekannt. Nachteilig bei dieser bekannten als Anschlußleiste dienenden Verteilerleiste ist, daß keine Überspannungsableiter eingesetzt werden können. Ferner ist aus der FR-A-2 327 653 eine Verbinderanordnung bekannt, bei der die Leiter an mit Sicherungselementen verbundene Anschlußklemmen angeschlossen sind. Die Aufgabe der vorliegenden Erfindung ist es, eine Verteilerleiste der eingangs genannten Art anzugeben, die den Einsatz von Überspannungsableitern ermöglicht und gleichzeitig eine vorteilhafte Verdrahtung der Verteilerleiste gestattet.

Diese Aufgabe wird für eine Verteilerleiste der eingangs genannten Art dadurch gelöst, daß im oberen Teil des Isolierstoffkörpers in Längsrichtung des Isolierstoffkörpers eine Anzahl von durch Zwischenwände getrennte nach oben offene Aufnahmekammern für Überspannungsableiter vorgesehen sind, daß an den den Anschlußklemmen benachbarten Seitenwänden der Aufnahmekammern mit den Anschlußklemmen verbundene Kontaktfedern angeordnet sind, und daß jeweils zwischen zwei gegenüberliegenden Kontaktfedern Teile einer Erdungsschiene in die Aufnahmekammern hineinragen.

Die erfindungsgemäße Verteilerleiste ist einfach herstellbar und weist ein geringes Bauvolumen bei geringer Bautiefe auf. Vorteilhaft ist, daß die Verteilerleiste gemäß der vorliegenden Erfindung sowhol als reine Anschlußleiste verwendet werden kann, als auch nachträglich beliebig mit Überspannungsableitern bestückt werden kann.

Eine Weiterbildung der erfindungsgemäßen Verteilerleiste ist dadurch gekennzeichnet, daß bei Verwendung von 3-Elektroden-Ableitern der Mittelanschluß des 3-Elektroden-Arbleiters zwischen in der Ebene der Erdungsschiene liegende Federschenkel der Erdungsschiene gehalten ist. Die erfindungsgemäße Verteilerleiste ermöglicht also das nachträgliche Einsetzen sowohl von 2-Elektroden-Ableitern als auch von 3-Elektroden-Ableitern.

Eine andere Weiterbildung der erfindungsgemäßen Verteilerleiste ist dadurch gekennzeichnet, daß auf den Zwischenwänden jeweils an den die Aufnahmekammern begrenzenden Seiten zumindest zwei Erhebungen angebracht sind, die zur Führung von auf einer Seite der Verteilerleiste herangeführten elektrischen Leitern zu einer auf der anderen Seite der Verteilerleiste angeordneten Doppelanschlußklemme dienen.

Eine weitere Ausgestaltung der erfindungsgemäßen Verteilerleiste ist dadurch gekennzeichnet, daß zumindest an einer Seitenwand der Verteilerleiste an der oberen und der unteren Längskante nebeneinanderliegende Drahtführungsschlitze vorgesehen sind, daß jeweils ein oberer Drahtführungschlitz und ein senkrecht darunter liegender Drahtführungschlitz einer Leitungsader zugeordnet sind, und daß an der Unterseite der Verteilerleiste in Längsrichtung nebeneinander eine vorgegebene Anzahl von Drahtführungsösen vorgesehen sind, wobei jede Drahtführungsösen mehreren Leitungsadern zugeordnet ist.

Dadurch wird erreicht, daß die ankommenden Außenleitungen leicht vorverdrahtet werden können, in dem jeweils die Sternvierer eines Bündel entsprechend ihres Farbcodes durch die an der Unterseite der Verteilerleiste angeordneten Drahtführungsösen geführt werden, und anschließend die einzelnen Leitungsadern mittels zwei einander zugeordneten Drahtführungsschlitze einzeln an die Verteilerleiste angeklemmt werden. Dadurch ist eine übersichtliche und den Leitungsverlauf eindeutig kennzeichnende Vorverdrahtung möglich.

Eine andere Ausgestaltung der erfindungsgemäßen Verteilerleiste ist dadurch gekennzeichnet, daß an jeder Ecke der Verteilerleiste ein Drahtführungskanal mit Öffnungen auf beiden Seiten der der jeweiligen Ecke benachbarten Seitenwänden vorgesehen ist, wobei die äußere Begrenzung des Drahtführungskanals aus zwei mit der Verteilerleiste verbundenen Stiften besteht, die einen schräg nach unten verlaufenden Einfürungsschlitz für die Leitungsadern begrenzen. Mit Hilfe dieser Drahtführungskanäle wird z. B. das seitliche Wegführen der anzuschließenden Rangierleitungen erheblich vereinfacht.

Die vorliegende Erfindung soll im folgenden anhand eines in der Figur dargestellten Ausführungsbeispieles näher erläutert werden. Es zeigen

Figur 1 eine perspektivische Teilansicht einer Verteilerleiste gemäß der Erfindung,

Figur 2 eine teilweise geschnittene Seitenansicht dieser Verteilerleiste,

Figur 3 eine Draufsicht der erfindungsgemäßen Verteilerleiste mit unterschiedlicher Bestückung von Überspannungsableitern,

Figur 4 eine um 180° gegenüber der in Fig. 2 dargestellten teilweise geschnittenen Seitenansicht gedrehte Seitenansicht,

Figur 5 und 6 perspektivische Darstellungen unterschiedlicher Erdschienen in Verbindung mit Überspannungsableitern, Kontaktfedern und Anschlußklemmen,

Figur 7 eine teilweise geschnittene Seitenansicht einer als Anschlußleiste dienenden mit Überspannungsableitung bestückten Verteilerleiste gemäß der Erfindung,

Figur 8 eine Draufsicht der in Fig. 7 dargestellten Verteilerleiste, und

Figur 9 eine um 180° gegenüber der in Fig. 7 dargestellten teilweise geschnittenen Seitenansicht gedrehte Seitenansicht.

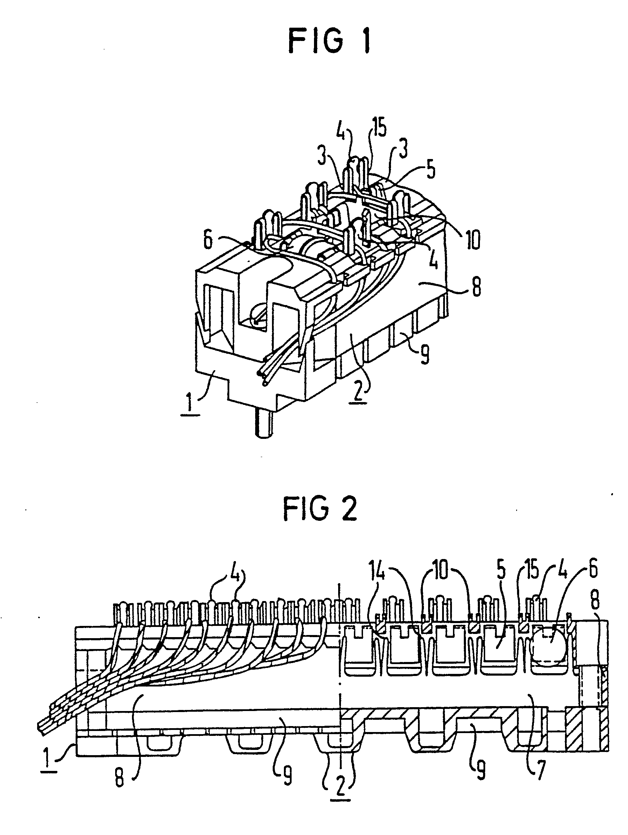

Die in den Figuren dargestellte Anschlußleiste 1 besteht aus einem Isolierstoffkörper 2, der in seinem oberen Teil Aufnahmekammern 3 zur Aufnahme von Überspannungsableitern aufweist. An den oberen Längsseiten des Isolierstoffkörpers 2 befinden sich in Aufnahmen eine Mehrzahl von Doppelanschlußklemmen 4, die mit an den benachbarten Seitenwänden der Aufnahmekammern 3 hineinragenden Kontaktfedern 5 verbunden sind. Bei der in Fig. 1 dargestellten Anschlußleiste 1 befindet sich in einer Aufnahmekammer 3 zwischen den Kontaktfedern 5 ein 3-Elektroden-Ableiter 6. Dabei ist der Mittelanschluß des 3-Elektroden-Ableiters 6 mit einer Erdungsschiene 7 (siehe Fig. 2) kontaktiert.

Der Isolierstoffkörper 2 besteht aus einem Oberteil 8 und einem Unterteil 9, welche durch Rastverbindungen zusammengehalten sind. Vor dem Zusammenfügen der beiden Teile wird eine entsprechende Erdungsschiene von unten in das Oberteil 8 gesteckt. Die Zwischenwände 10 der Aufnahmekammern 3 sind in der Mitte jeweils im unteren Teil geschlitzt. Ebenso ist der Boden der Aufnahmekammern 3 in der Mitte zu den Zwischenwänden 10 hin geschlitzt, so daß Stege der Erdungsschiene durch diese Schlitze in die Aufnahmekammern 3 hineinragen.

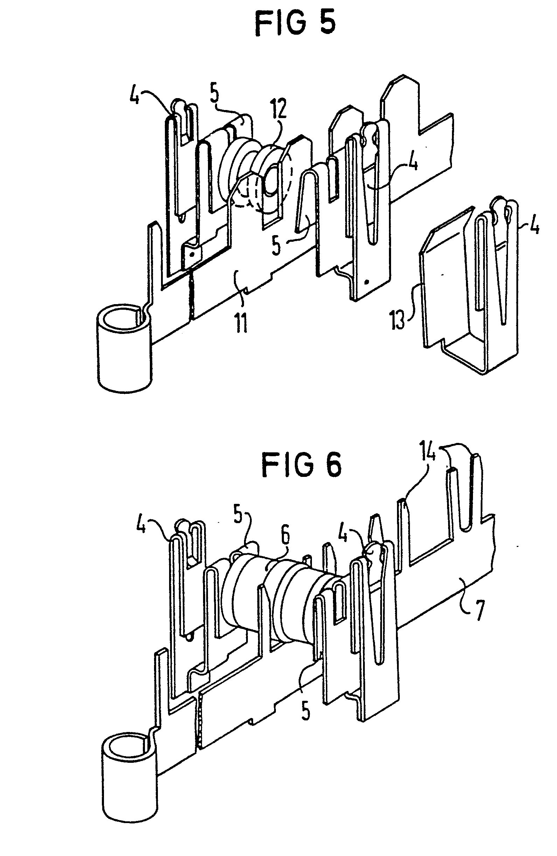

Im folgenden sollen anhand der Figuren 5 und 6 die Erdungsschienen 7 und 11 beschrieben werden. Da die erfindungsgemäße Verteilerleiste sowohl mit 2-Elektroden-Ableitern 12 als auch mit 3-Elektroden-Ableiter 6 bestückbar sein soll, sind unterschiedliche Erdungsschienen notwendig. Beide Erdungsschienen bestehen im wesentlichen aus einem kammartigen Metallstreifen, der an beiden Enden umgebogen ist um eine lochartige Öse für eine erdkontaktherstellende Befestigungsschraube zu bilden. Die Erdungsschiene 11 für 2-Elektroden-Ableiter 12 kann wie in der Fig. 5 dargestellt ist Freischnitte aufweisen, so daß der einzelne Ableiter in den Aufnahmekammern lediglich an den Seiten mit der Erdungsschiene kontaktiert wird. Die Erdungschiene 7 für 3-Elektroden-Ableiter 6 weist pro Kammer zwei Federschenkel 14 auf, so daß ein sicherer Kontakt zwischen Mittelanschluß des Ableiters und der Erdungsschiene 7 gewährleistet ist.

Den Fig. 5 und 6 ist außerdem die Verbindung zwischen Doppelanschlußklemme 4 und Kontaktfeder 5 zu entnehmen. Dabei kann das jeweilige aus Kontaktfeder 5 und Doppelanschlußklemme 4 bestehende Bauelement zweistückig ausgebildet sein oder, wie in Fig. 5 auch angedeutet ist, einstückig ausgebildet sein. Mit 13 ist eine ebenfalls mögliche Ausgestaltung der Kontaktfeder angedeutet.

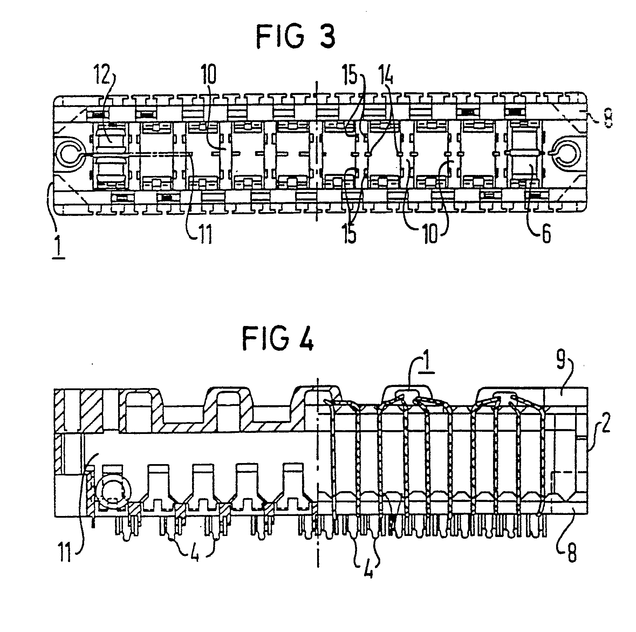

Aus den Fig. 2 bis 4 ist die Bestückung der Verteilerleiste mit Überspannungsableitern zu entnehmen, wobei jeweils in der rechten Hälfte der Figuren die Bestückung der Verteilerleiste mit 3-Elektroden-Ableitern 6 dargestellt ist, während in der linken Hälfte der Fig. 2 bis 4 die Bestückung der Verteilerleiste mit 2-Elektroden-Ableitern 12 angedeutet ist. Den Fig. 2 bis 4 läßt sich weiterhin entnehmen, daß die gegenüberliegenden Doppelanschlußklemmen, bezogen auf die Aufnahmekammern 3, gegeneinander versetzt angeordnet sind. Da jeweils zwei einer Aufnahmekammer 3 zugeordnete Doppelanschlußklemmen, bezogen auf die Aufnahmekammern 3, gegeneinander versetzt angeordnet sind. Da jeweils zwei einer Aufnahmekammer 3 zugeordnete Doppelanschlußklemmen einer Doppelader zugeordnet sind, läßt sich so eine exakte Drahtführung erreichen. Diese Drahtführung wird weiter dadurch erheblich erleichtert, daß auf den Zwischenwänden 10 Erhebungen 15 angebracht sind, zwischen denen die von einer Seite der Verteilerleiste herangeführten elektrischen Leiter zu einer auf der anderen Seite der Verteilerleiste angeordneten Doppelanschlußklemme geführt werden können.

Weiterhin ist den Figuren 2 bis 4 zu entnehmen, daß an den oberen und unteren Längskanten des Isolierstoffkörpers Drahtaufnahmen vorgesehen sind, wobei jeweils eine obere und eine untere Drahtaufnahme einer Ader einer Leitung zugeordnet ist, und daß an der Unterseite der Verteilerleiste für eine vorgegebene Anzahl von zusammengehörigen Drahtaufnahmen eine Öse vorhanden ist, durch welche die an- bzw. abgehenden Adern einer Leitung für eine bestimmte Anzahl von Drahtaufnahmen geführt sind.

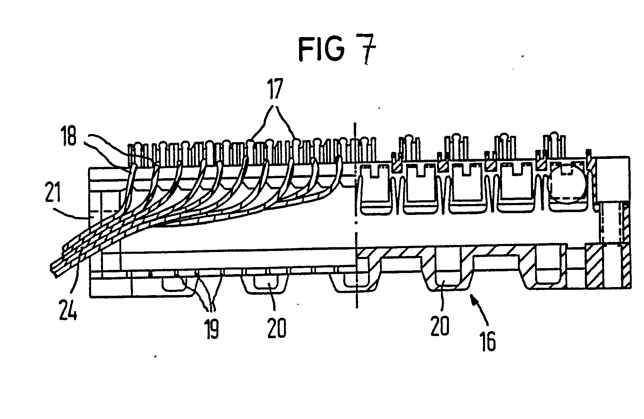

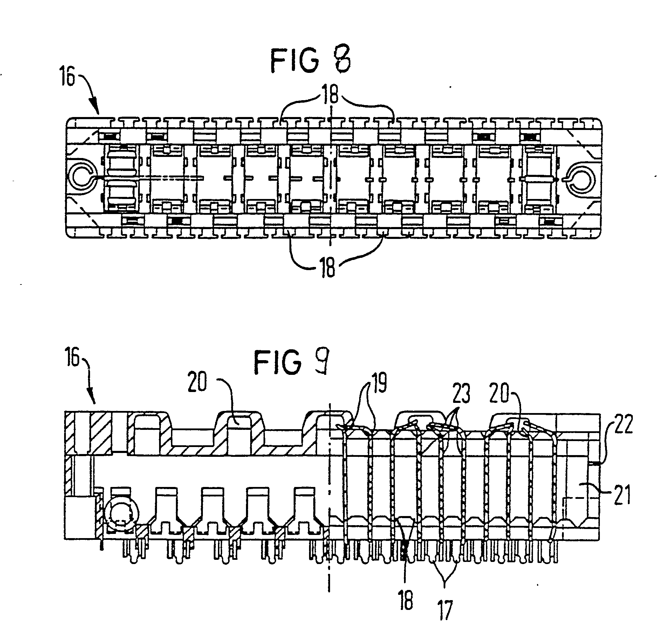

Im folgenden soll die gemäß der vorliegenden Erfindung vorgesehene Drahtführung beschrieben werden. In den Figuren 7 bis 9 ist eine als Anschlußleiste dienende, mit Überspannungsableitern bestückte Verteilerleiste dargestellt. Die den Anschluß elektrischer Leiter gestattenden Anschlußklemmen 17 sind an den oberen Längsseiten eines Isolierstoffkörpers angeordnet. An den oberen Längskanten der Verteilerleisten 16 sind die Drahtführungsschlitze 18 nebeneinander angeordnet. Den Figuren 7 und 9 lassen sich die an den unteren Längsseiten der Verteilerleiste 16 nebeneinander angeordneten Drahtführungsschlitze 19 entnehmen. An der Unterseite der erfindungsgemäßen Verteilerleiste — siehe z. B. Fig. 7 — sind die Drahtführungsösen 20 angeordnet. Dabei können diese Drahtführungsösen 20 aus Symmetriegründen in der Mitte der Unterseite angeordnet sein.

In der Fig. 9 ist die Verdrahtung von ankommenden Aussenleitungen dargestellt. Dabei sind jeweils vier Leitungsadern einer Außenleitung zusammengefaßt und jeweils durch eine Drahtführungsöse 20 auf der Unterseite der Verteilerleiste 16 geführt. Anschließend wird, wie dargestellt, jede Leitungsader in zwei Drahtführungschlietzen, die einander zugeordnet sind, festgeklemmt. Da die einzelnen Leitungsadern farblich gekennzeichnet sind ergibt sich so eine übersichtliche und den Leitungsverlauf eindeutig kennzeichnende Verdrahtung. Von Vorteil ist, daß diese Verdrahtung der ankommenden Außenleitungen vor der endgültig Befestigung der Verteilerleiste 16 am Verteilergestell vorgenommen werden kann. Nach Befestigung der Verteilerleiste 16 am Verteilergestell müssen die einzelnen Leitungsadern der ankommenden Außenleitungen lediglich an den Anschlußklemmen 17 kontaktiert werden.

Nach Anschluß der Außenleitungen 23 können die Rangierleitungen 24 angeschlossen werden. Bei der Verdrahtung der Rangierleitungen 24 kann auf die an der unteren Längskante der Verteilerleiste angeordneten Drahtführungsschlitze verzichtet werden. Die mit der Anschlußklemme 17 verbundenen Rangierleitungen werden dann durch die oberen Drahtführungsschlitze geführt und anschließend seitlich durch die Drahtführungskanäle 21 gebündelt weitergeführt. Durch den Einführungsschlitz 22 lassen sich die abgehenden Rangierleitungen leicht in den Drahtführungskanal 21 einführen, in dem sie aufgrund der Aufgestaltung des Einführungsschlitzes 22 sicher geführt sind.

Obwohl, wie vorher beschrieben worden ist, für das Wegführen der Rangierleitungen keine unteren Drahtführungsschlitze notwendig sind, ist es zweckmäßig, die Verteilerleiste symmetrisch auszubilden, so daß unabhängig von der Ausbildung der Verteilerleiste die ankommenden Außenleitungen sowohl von vorne als auch von hinten herangeführt werden können, je nach Anordnung der Verteilerleiste 1 bzw. 16 im Gestellaufbau.

**Patentansprüche**

1. Verteilerleiste (z. B. 1) mit einer Mehrzahl von den abisolierfreien Anschluß elektrischer Leiter gestattenden Doppelanschlußklemmen (4), die an den oberen Längsseiten eines Isolierstoffkörpers (2) in Aufnahmen gehalten sind, wobei die Verteilerleiste (z. B. 1) einen annähernd quadratischen Querschnitt aufweist, dadurch gekennzeichnet, daß im oberen Teil des Isolierstoffkörpers (2) in Längsrichtung des Isolierstoffkörpers (2) eine Anzahl von durch Zwischenwände (10) getrennte, nach oben offene Aufnahmekammern (3) für Überspannungsableiter (6, 12) vorgesehen sind, daß an den den Anschlußklemmen (4) benachbarten Seitenwänden der Aufnahmekammern (3) mit den Anschlußklemmen (4) verbundene Kontaktfedern (5) angeordnet sind, und daß jeweils zwischen zwei gegenüberliegenden Kontaktfedern (5) Teile einer Erdungsschiene (7, 11) in die Aufnahmekammern (3) hineinragen.

2. Verteilerleiste nach Anspruch 1, dadurch gekennzeichnet, daß bei Verwendung von 3-Elektroden-Ableitern (6) der Mittelanschluß des Elektroden des 3-Elektroden-Ableiters (6) zwischen in der Ebene der Erdungsschiene (7) liegenden Federschenkel (14) der Erdungsschiene (7) gehalten ist.

3. Verteilerleiste nach Anspruch 1 oder 2, dadurch gekennzeichnet, daß auf den Zwischenwänden (10) jeweils an den die Aufnahmekammern (3) begrenzenden Seiten zumindest zwei Erhebungen (15) angebracht sind.

4. Verteilerleiste nach einem der vorhergehenden Ansprüche, dadurch gekennzeichnet, daß zumindest an einer Seitenwand der Verteilerleiste (16) an der oberen und der unteren Längskante nebeneinanderliegende Drahtführungsschlitze (18, 19) vorgesehen sind, daß jeweils ein oberer Drahtführungsschlitz (18) und ein senkrecht darunterliegender Drahtführungsschlitz (19) einer Leitungsader zugeordnet sind, und daß an der Unterseite der Verteilerleiste (16) in Längsrichtung nebeneinander eine vorgegebene Anzahl von Drahtführungsösen (20) vorgesehen sind, wobei jede der Drahtführungsösen (20) mehreren Leitungsadern zugeordnet ist.

5. Verteilerleiste nach Anspruch 4, dadurch gekennzeichnet, daß an jeder Ecke der Verteilerleiste (16) ein Drahtführungskanal (21) mit Öffnungen auf beiden Seiten der der jeweiligen Ecke benachbarten Seitenwänden vorgesehen ist, wobei die äußere Begrenzung des Drahtführungskanals (21) aus zwei mit der Verteilerleiste verbundenen Stifte besteht, die einen schräg nach unten verlaufenden Einführungsschlitz (22) für die Leitungsadern begrenzen.

**Claims**

1. A distributing strip (e.g. 1) comprising a plurality of double connection terminals (4) which allow electric conductors to be connected without the need to strip them of their insulation and which are held in holders on the upper longitudinal sides of an insulating body (2), where the distributor strip (e.g. 1) has an approximately square cross-section, characterised in that a number of upwardly open receiving chambers (3) separated by partition walls (10), are provided for surge arresters (6, 12), and are arranged in the upper part of the insulating component (2) in the longitudinal direction of the insulating component (2), that those side walls of the receiving chambers (3) which are adjacent to the connection terminals (4) are provided with contact springs (5) which are connected to the connection terminals (4), and that in each case between two opposing contact springs (5) parts of an earthing bar (7, 11) project into the receiving chambers (3).

2. A distributor strip as claimed in Claim 1, characterised in that when 3-electrode arresters (6) are used, the central terminal of the electrodes of the 3-electrode arrester (6) is held between spring legs (14) of the earthing bar (7) which lie in the plane of the earthing bar (7).

3. A distributor strip as claimed in Claim 1 or 2, characterised in that the partition walls (10) are each provided with at least two upstands (15) on the sides adjacent to the receiving chambers (3).

4. A distributor strip as claimed in one of the preceding Claims, characterised in that at least one side wall of the distributor strip (16) is provided with wire guidance slots (18, 19) which are arranged one beside another at the upper and lower longitudinal edges, that in each case one upper wire guidance slot (18) and a wire guidance slot (19) arranged verticaly beneath it are assigned to a line wire, and that a predetermined number of wire guidance lugs (20) are provided on the unterneath of the distributor strip (16) one beside another in the longitudinal direction, where each of the wire guidance lugs (20) is assigned to a plurality of line wires.

5. A distributor strip as claimed in Claim 4, characterised in that at each corner of the distributor strip (16) a wire guidance channel (21) is provided having openings adjacent the side walls on both sides of the respective corner, where the outer periphery of the wire guidance channel (21) consists of two pins which are connected to the distributor strip and which delimit an insertion slot (22) for the line which extends obliquely downwards.

## Revendications

1. Barrette de distribution (par exemple 1) comportant une multiplicité de bornes de raccordement doubles (4), permettant le raccordement sans dénudage de conducteurs électriques et qui sont maintenues sur les côtés longitudinaux supérieurs d'un corps en matériau isolant (2), dans des évidements, la barrette de distribution (par exemple 1) possédant une section transversale approximativement carrée, caractérisée par le fait qu'un nombre de chambres de logement (3), ouvertes vers le haut, séparées par des cloisons (10) et prévues pour des dispositifs (6, 12) de dérivation des surtensions est prévu dans la partie supérieure du corps en matériau isolant (2), dans la direction longitudinale de ce dernier, que sur les parois latérales, voisines des bornes de raccordement (4) des chambres de logement (3) se trouvent disposés des ressorts de contact (5) reliés aux bornes de raccordement (4) et que des éléments d'un rail de mise à la terre (7, 11) pénètrent dans les chambres de logement (3) respectivement entre deux ressorts de contact disposés en vis-à-vis.

2. Barrette de distribution suivant la revendication 1, caractérisée par le fait que dans le cas de l'utilisation de dispositifs (6) de dérivation des surtensions à 3 électrodes, la borne médiane des électrodes de ce dispositif (6) est maintenue entre les branches élastiques (14) du rail de mise à la terre (7), qui sont situées dans le plan de ce rail.

3. Barrette de distribution suivant la revendication 1 ou 2, caractérisée par le fait qu'au moins deux appendices saillants (15) sont prévus sur les cloisons (10), respectivement sur les faces délimitant les chambres de logement (3).

4. Barrette de distribution suivant l'une des revendications précédentes, caractérisée par le fait qu'il est prévu des fentes (18, 19) de guidage de fils, disposées côte-à-côte sur le bord longitudinal supérieur et sur le bord longitudinal inférieur, au moins sur une paroi latérale de la barrette de distribution (16), que respectivement une fente supérieure (18) de guidage de fils et une fente (19) de guidage de fils, située verticalement au-dessous de la précédente, sont associées à un fil d'une ligne et qu'il est prévu un nombre prédéterminé d'œillets (20) de guidage de fils, disposés côte-à-côte dans la direction longitudinale, sur la face inférieure de la barrette de distribution (16), chacun des œillets (20) de guidage de fils étant associé à plusieurs fils d'une ligne.

5. Barrette de distribution suivant la revendication 4, caractérisée par le fait qu'il est prévu, au niveau de chaque coin de la barrette de distribution (16), un canal (21) de guidage de fils, comportant des ouvertures situées des deux côtés des parois latérales voisines du coin respectif, la limitation extérieure du canal (21) de guidage de fils étant formée par deux broches reliées à la barrette de distribution et qui limitent une fente d'insertion (22), s'étendant obliquement vers le bas, pour les fils de la ligne.

# FIG 1

# FIG 2

# FIG 3

# FIG 4

0 121 223

FIG 5

FIG 6

3

# FIG 7

FIG 8

16

18

18

FIG 9

16

20  19  23  20

22

21

18  17